# EUROPEAN PATENT APPLICATION

(11) **EP 4 804 404 A1**
(43) Date of publication of application: **09.09.2026**
(21) Application number: 26161579.3
(22) Date of filing: 02.03.2026
(51) Int. Cl.: H03F 3/08, H03F 3/45, H03G 3/30

(54) **AMPLIFIER CIRCUITS WITH AMBIENT LIGHT CANCELATION**

(30) Priority: 05.03.2025 US 202519071311
(71) Applicant: Avago Technologies International Sales Pte. Limited, Singapore 768923 (SG)
(72) Inventor: Agarwal, Rishi Chandra, Irvine, CA, 92618 (US)
(74) Representative: Grünecker Patent- und Rechtsanwälte PartG mbB

(57) **Abstract**

Amplifier circuit that can provide improvements in terms of performance and power efficiency. An example integrated circuit includes a first pin connectable to a photodiode to receive an input current from the photodiode; an amplifier connected to the first pin; a second pin connected to the amplifier to provide an output voltage indicative of the input current from the photodiode; a current source circuit connected between the first pin and the second pin; an analog-to-digital converter (ADC) circuit connected between the second pin and the current source circuit; and a controller configured to, during a first time period, measure a first current associated with the photodiode using the ADC circuit and, during a second time period, cause the current source circuit to provide a second current to the amplifier to cancel the first current.

## Description

### BACKGROUND

The present disclosure relates, in general, to present disclosure relates, in general, to the design and functionality of electronic circuits for use in a variety of electronic applications and devices. More specifically, the present disclosure relates to the design of amplifier circuits.

### BRIEF DESCRIPTION OF THE DRAWINGS

FIG. 1 shows a diagram illustrating example components of an integrated circuit, in accordance with some aspects of the disclosure.
FIG. 2 shows another diagram illustrating example components of the integrated circuit of FIG. 1, in accordance with some aspects of the disclosure.
FIG. 3 shows a diagram illustrating an example timing sequence that can be implemented in the integrated circuit of FIG. 1, in accordance with some aspects of the disclosure.
FIG. 4 shows a diagram illustrating another example timing sequence that can be implemented in the integrated circuit of FIG. 1, in accordance with some aspects of the disclosure.

### DETAILED DESCRIPTION

In the following description, for the purposes of explanation, numerous details are set forth to provide a thorough understanding of the disclosure. It will be apparent to one skilled in the art, however, that other aspects can be practiced without some details. Different examples are described herein, and while various features are ascribed to the examples, it should be appreciated that the features described with respect to one example may be incorporated with other examples as well. By the same token, however, no single feature or features of any described example should be considered essential to every example, as other examples may omit such features.

When an element is referred to herein as being "connected" or "coupled" to another element, it is to be understood that the elements can be directly connected to the other element, or have intervening elements present between the elements. In contrast, when an element is referred to as being "directly connected" or "directly coupled" to another element, it should be understood that no intervening elements are present in the "direct" connection between the elements. However, the existence of a direct connection does not exclude other connections, in which intervening elements may be present.

When an element is referred to herein as being "disposed" in some manner relative to another element (e.g., disposed on, disposed between, disposed under, disposed adjacent to, or disposed in some other relative manner), it is to be understood that the elements can be directly disposed relative to the other element (e.g., disposed directly on another element), or have intervening elements present between the elements. In contrast, when an element is referred to as being "disposed directly" relative to another element, it should be understood that no intervening elements are present in the "direct" example. However, the existence of a direct disposition does not exclude other examples in which intervening elements may be present.

Likewise, when an element is referred to herein as being a "layer", it is to be understood that the layer can be a single layer or include multiple layers. For example, a conductive layer can include multiple different conductive materials or multiple layers of different conductive materials, and a dielectric layer may comprise multiple dielectric materials or multiple layers of dielectric materials. When a layer is described as being coupled or connected to another layer, it is to be understood that the coupled or connected layers may include intervening elements present between the coupled or connected layers. In contrast, when a layer is referred to as being "directly" connected or coupled to another layer, it should be understood that no intervening elements are present between the layers. However, the existence of directly coupled or connected layers does not exclude other connections in which intervening elements may be present.

Moreover, the terms left, right, front, back, top, bottom, forward, reverse, clockwise and counterclockwise are used for purposes of explanation only and are not limited to any fixed direction or orientation. Rather, they are used merely to indicate relative locations and/or directions between various parts of an object and/or components.

Furthermore, unless otherwise indicated, all numbers used herein to express quantities, dimensions, and so forth should be understood as being modified in all instances by the term "about". In this application, the use of the singular includes the plural unless specifically stated otherwise, and use of the terms "and" and "or" means "and/or" unless otherwise indicated. Moreover, the use of the terms "including" and "having", as well as other forms, such as "includes", "included", "has", "have", and "had", should be considered non-exclusive. Also, terms such as "element" or "component" encompass both elements and components comprising one unit and elements and components that comprise more than one unit, unless specifically stated otherwise.

While some features and aspects have been described with respect to the examples, one skilled in the art will recognize that numerous modifications are possible. For example, the methods and processes described herein may be implemented using hardware components, custom integrated circuits (ICs), programmable logic, and/or any combination thereof. Further, while various methods and processes described herein may be described with respect to particular structural and/or functional components for ease of description, methods provided by various embodiments are not limited to any particular structural and/or functional architecture but instead can be implemented in any suitable hardware configuration. Similarly, while some functionality is ascribed to one or more system components, unless the context dictates otherwise, this functionality can be distributed among various other system components in accordance with the several embodiments.

Moreover, while the procedures of the methods and processes described herein are described in a particular order for ease of description, unless the context dictates otherwise, various procedures may be reordered, added, and/or omitted in accordance with various implementations. Moreover, the procedures described with respect to one method or process may be incorporated within other described methods or processes; likewise, system components described according to a particular structural architecture and/or with respect to one system may be organized in alternative structural architectures and/or incorporated within other described systems. Hence, while various examples are described with or without some features for ease of description and to illustrate aspects of those embodiments, the various components and/or features described herein with respect to a particular example can be substituted, added and/or subtracted from among other described embodiments, unless the context dictates otherwise. Consequently, although several examples are described above, it will be appreciated that the disclosure is intended to cover all modifications and equivalents within the scope of the following claims.

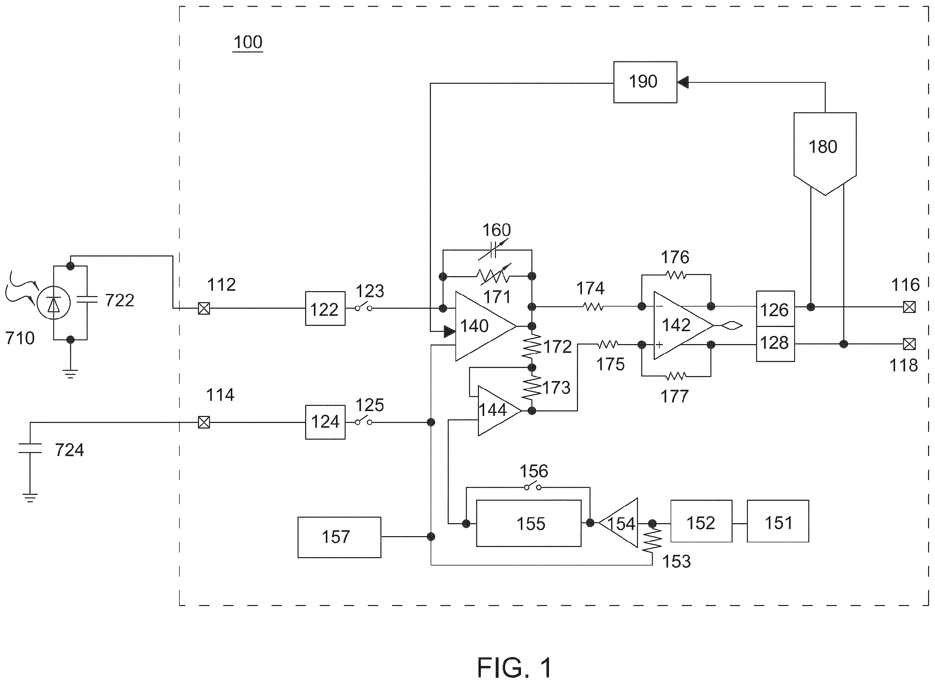

Referring to FIG. 1, a diagram illustrating example components of an integrated circuit 100 is shown, in accordance with some aspects of the disclosure. The integrated circuit 100 can be an amplifier circuit such as a transimpedance amplifier (TIA) circuit, for example, or another similar type of circuit. The integrated circuit 100 can generally be used to convert an input current signal into an output voltage signal. As shown in FIG. 1, the integrated circuit 100 can include various pins, including a pin 112, a pin 114, a pin 116, and a pin 118. Additionally, the integrated circuit 100 can include a filter 122, a switch 123, a filter 124, a switch 125, an amplifier 140, an amplifier 142, an amplifier 144, a reference generator 151, a voltage to current converter (V2I) block 152, a resistor 153, a buffer 154, a filter 155, a switch 156, a photodiode reference generator 157, a capacitor 160, a resistor 171, a resistor 172, a resistor 173, a resistor 174, a resistor 175, a resistor 176, a resistor 177, an analog-to-digital converter (ADC) circuit 180, and a controller 190. As also shown in FIG. 1, the integrated circuit 100 can be connectable to various external electronic components including a photodiode 710, a capacitor 722, and a capacitor 724.

The integrated circuit 100 can be provided within a single package that is then connected to a higher level system circuit. For example, the integrated circuit 100 can be provided within a package and connected to a printed circuit board (PCB) of an electronic device. The electronic device can be any suitable type of electronic device such as a wearable device (e.g., smart watch, biometric device, other types of wearable healthcare devices) or a smartphone, for example, among other possibilities. The electronic components including the photodiode 710, the capacitor 722, and the capacitor 724 can be external components in the sense that they may not be provided within the same package as the integrated circuit 100. Rather, in some examples, the photodiode 710, the capacitor 722, and the capacitor 724 can be provided on the printed circuit board that the integrated circuit 100 can be connected to.

The photodiode 710 can be implemented using various suitable types of photodiode components. For example, the photodiode 210 can be a semiconductor diode that is sensitive to photon radiation (e.g., visible light, infrared light, ultraviolet light, etc.). Generally, the photodiode 710 can produce an electrical current when it absorbs photons, and the integrated circuit 100 can sense the electrical current produced by the photodiode 710. The capacitor 722 can be included in parallel with the photodiode 710 to store energy via charge that is accumulated on the plates of the capacitor 722. As shown in FIG. 1, the integrated circuit 100 can be connectable to the photodiode 710 and the capacitor 722 via the pin 112. The capacitor 724 can also be connectable to the integrated circuit 100, in this case via the pin 114. For example, as shown in FIG. 1, the capacitor 724 can thereby be connected between the pin 114 and ground. In some examples, the integrated circuit 100 can be connected to multiple photodiodes, not just the photodiode 710 as illustrated in the example shown in FIG. 1.

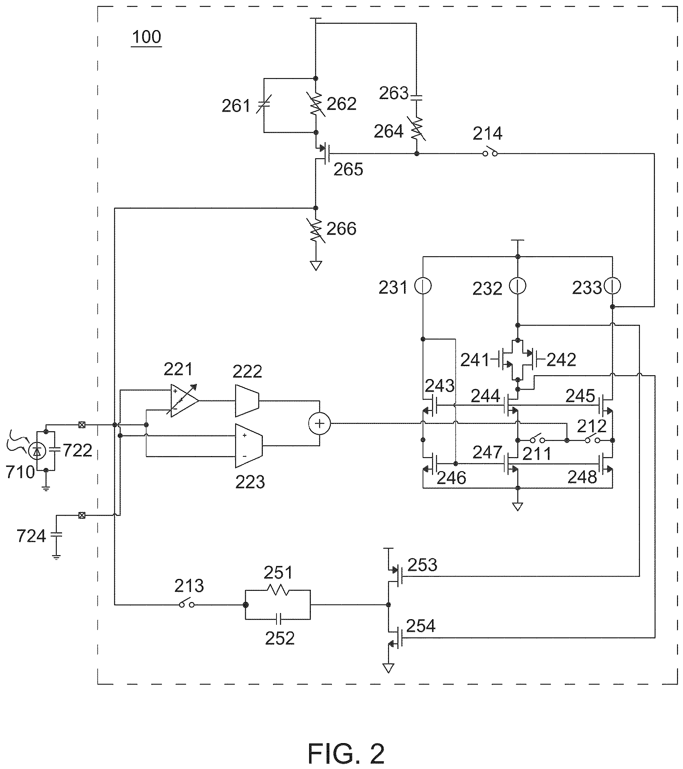

In photo sensing applications, the dynamic range of the TIA circuit is a performance metric that costs power and signal to noise ratio (SNR). Depending on the application, varying levels of ambient light can be sensed by the photodiode (e.g., the photodiode 710), the ambient light can create an ambient current signal that distorts the true current signal that is intended to be measured by the TIA circuit. However, the integrated circuit 100 can be used to both measure and cancel this ambient current produced by the photodiode 710. As a result, the integrated circuit 100 can free up the useful dynamic range of the amplifier 140 in particular, and thereby provide better power efficiency and higher signal to noise ratio when compared to some previous amplifier circuit designs. While FIG. 1 and FIG. 2 in particular show several examples of both components and arrangements of components that can be used to implement the integrated circuit 100, it should be noted that these are merely examples, and a variety of changes can be made to the layout of the integrated circuit 100 without departing from the scope of the disclosure.

The pin 112, the pin 114, the pin 116, and the pin 118 can generally be used to form electrical connections between the integrated circuit 100 and the printed circuit board that the integrated circuit 100 can be connected to. The pin 112, the pin 114, the pin 116, and the pin 118 can be implemented in various ways, including by using various types of conductive materials and electrical connector configurations. The pin 112 in particular can be connectable to the photodiode 710 to receive an input current from the photodiode 710. As such, the pin 112 can be referred to as a "photodiode" or "PD" pin of the integrated circuit 100. The pin 114 can receive a reference voltage (e.g., via the photodiode reference generator 157, the capacitor 724) and can thus be referred to as a "reference" or "REF" pin of the integrated circuit 100. The pin 116 and the pin 118 can collectively provide a differential output voltage indicative of the input current from the photodiode 710. As such, the pin 116 can be referred to as an "OUT_N" pin of the integrated circuit 100 and the pin 118 can be referred to as an "OUT_P" pin of the integrated circuit 100. While providing a differential output voltage in this manner can be advantageous in various applications, it should be noted that alternative designs of the integrated circuit 100 can also be implemented using a single output pin or by using more than two output pins.

The filter 122 can be implemented using various suitable types and configurations of filters. For example, the filter 122 can be an electromagnetic interference (EMI) filter implemented using various suitable types of electronic components (e.g., capacitors, resistors, inductors, etc.). As shown in FIG. 1, the filter 122 can be connected between the pin 112 and the switch 123, and the switch 123. The filter 122 can generally be included to mitigate the effects of electromagnetic interference that may occur within the integrated circuit 100. The switch 123 can be connected between an inverting input terminal of the amplifier 140 and the filter 122, and the switch 123 can be controlled by the controller 190. Similarly, the filter 124 can be implemented using various suitable types and configurations of filters. For example, the filter 124 can be an electromagnetic interference filter implemented using various suitable types of electronic components (e.g., capacitors, resistors, inductors, etc.). As shown in FIG. 1, the filter 124 can be connected between the pin 114 and the switch 125. The filter 124 can again be included to mitigate the effects of electromagnetic interference that may occur within the integrated circuit 100. The switch 125 can be connected between a noninverting input terminal of the amplifier 140 and the filter 124, and the switch 125 can be controlled by the controller 190.

The amplifier 140, as noted in part above, can include an inverting input terminal, a noninverting input terminal, and an output terminal. The amplifier 140 can be implemented using various suitable types of amplifier devices and circuits (e.g., various types of operational amplifiers ("op-amps"), etc.). The amplifier 140 can generally be used to amplify the input current that is received from the photodiode 710 at the pin 112 and convert the input current that is received from the photodiode 710 at the pin 112 to a usable output voltage. As shown in FIG. 1, the capacitor 160 and the resistor 171 can be connected in parallel between the output terminal of the amplifier 140 and the inverting input terminal of the amplifier 140. The capacitor 160 can be a variable capacitor and the resistor 171 can be a variable resistor. The controller 190 can generally control the variable capacitance of the capacitor 160 and/or the variable resistance of the resistor 171 to adjust various parameters associated with the amplifier 140 (e.g., to adjust the gain, etc.).

The amplifier 142 can be implemented as a single-ended to differential (S2D) amplifier, in some examples, to create the differential output voltages that can be provided via the pin 116 and the pin 118. The amplifier 142 can be implemented using various suitable types of amplifier devices and circuits (e.g., various types of operational amplifiers, etc.). As shown in FIG. 1, the resistor 176 can be connected between a first output terminal of the amplifier 142 and a first input terminal of the amplifier 142, and the resistor 177 can be connected between a second output terminal of the amplifier 142 and a second input terminal of the amplifier 142. Additionally, the filter 126 can be connected between the first output terminal of the amplifier 142 and the pin 116, and the filter 128 can be connected between the second output terminal of the amplifier 142 and the pin 118. The filter 126 and the filter 128 can each be implemented using various suitable types and configurations of filters. For example, the filter 126 and the filter 128 can be electromagnetic interference filters and can be implemented using various suitable electronic components (e.g., capacitors, resistors, inductors, etc.).

The amplifier 144 can be implemented as an inverting amplifier, in some examples, to provide an inverted output form the amplifier 140 to the amplifier 142 within the integrated circuit 100. The amplifier 144 can also be implemented using various suitable types of amplifier devices and circuits (e.g., various types of operational amplifiers, etc.). As shown in FIG. 1, the resistor 172 along with the resistor 173 can be connected in series between the output terminal of the amplifier 140 and the output terminal of the amplifier 144. Additionally, a first input terminal of the amplifier 144 can be connected between the resistor 172 and the resistor 173, and a second input terminal of the amplifier 144 can be connected to the filter 155 and the switch 156.

The reference generator 151, the control block 152, and the photodiode reference generator 157 can generally represent different variables managed by the controller 190. For example, the reference generator 151, the voltage to current converter 152, and the photodiode reference generator 157 can provide a level-shifting voltage to shift the output differential voltage provided by the integrated circuit 100. Together with the resistor 153, the buffer 154, the filter 155, and the switch 156, the reference generator 151, the voltage to current converter 152, and the photodiode reference generator 157 can generally represent a level-shifting scheme implemented by the integrated circuit 100 (e.g., via the controller 190). The filter 155 can be implemented using various suitable components and can, in some examples, be a low pass filter. The controller 190 itself can also be implemented in various suitable manners. For example, the controller 190 can be implemented using one or multiple separate control components or devices, or using a single control component or device (e.g., a timing controller, etc.). The controller 190 can generally include memory and processing circuitry to execute machine-readable instructions stored in the memory to perform various control actions associated with the integrated circuit 100 as detailed herein.

The ADC circuit 180 can generally be implemented as a lower resolution ADC circuit to reduce the number of components needed to implement the ADC circuit 180 and thereby reduce the cost of the integrated circuit 100. For example, the resolution of the ADC circuit 180 can be between 2 bits and 4 bits. The ADC circuit 180, as shown in FIG. 1, can be connected to the pin 116, the pin 118, and the controller 190. The output of the ADC circuit 180 can be indicative of a current range associated with the ambient current produced by the photodiode 710. For example, if the resolution of the ADC circuit 180 is 3 bits, an output of 000 can indicate that the ambient current produced by the photodiode 710 is in the range of 0 microamperes (µA) to 4 microamperes. Then, an output of 001 can indicate that the ambient current produced by the photodiode 710 is in the range of 4 microamperes to 8 microamperes, an output of 010 can indicate that the ambient current produced by the photodiode 710 is in the range of 8 microamperes to 16 microamperes, and so on. The ADC circuit 180 can be implemented using various suitable electronic components (e.g., transistors, capacitors, resistors, inductors, etc.).

Referring to FIG. 2, another diagram illustrating example components of an integrated circuit 100 is shown, in accordance with some aspects of the disclosure. It should be noted that some of the components of the integrated circuit 100 overlap with the components of the integrated circuit 100 as shown in FIG. 1 and may be provided with different reference numerals in FIG. 2 to help illustrate additional and/or alternative functionality of the integrated circuit 100. Both FIG. 1 and FIG. 2 are intended to help illustrate the functionality of the integrated circuit 100, and are not intended to be limiting to components that may or may not be included in the integrated circuit 100. Most notably, as will be detailed further below, FIG. 2 shows an example of a current source circuit that can be implemented in the integrated circuit 100 to at least partially cancel the ambient current associated with the photodiode 710.

The example current source circuit as shown in FIG. 2 can be a floating current source circuit that includes a capacitor 261, a resistor 262, a transistor 265, and a resistor 266. The current source circuit can be connected between the pin 116 and the pin 112 and/or between the pin 118 and the pin 112, for example. The controller 190 can cause the current source circuit to perform different functionality within the integrated circuit 100 during different time periods (phases) by controlling one or more of the components of the integrated circuit 100 as shown in FIG. 1 or in FIG. 2. As shown in FIG. 2, a switch 214, a capacitor 263, and a resistor 264 can be connected to the current source circuit. The capacitor 263 can have varying levels of capacitance (e.g., 60 picofarads, etc.) and can be connected between he switch 214 and the current source circuit to hold a bias for the current source circuit. Also, the resistor 264 can be a variable resistor that is connected between the switch 214, the transistor 265, and the capacitor 263.

As shown in FIG. 2, a gate terminal of the transistor 265 can be connected to the switch 214 and to the resistor 264. Moreover, the capacitor 261 can be a variable capacitor, the resistor 262 can be a variable resistor, and the resistor 266 can also be a variable resistor. The capacitor 261 and the resistor 262 can be connected in parallel between the capacitor 263 and the transistor 265. Then, the resistor 266 can be connected between the transistor 265 and ground. The resistor 266 can also be connected to the amplifier 140 as shown in FIG. 1 and the amplifier 221 as shown in FIG. 2. The controller 190 can generally cause the current source circuit including the capacitor 261, the resistor 262, the transistor 265, and the resistor 266 to provide a compensatory current to the amplifier 140 (e.g., to the inverting input terminal of the amplifier 140), based on the ambient current associated with the photodiode 710 as measured using the ADC circuit 180, such that the compensatory current (e.g., a second current) at least partially cancels the ambient current (e.g., a first current) associated with the photodiode 710.

The integrated circuit 100 as shown in FIG. 2 can also include additional components beyond those associated with the current source circuit. In particular, the integrated circuit 100 as shown in FIG. 2 can include a switch 211, a switch 212, and a switch 213 in addition the switch 214. The switch 211, the switch 212, the switch 213, and the switch 214 can each be implemented using various suitable types of switches (e.g., using different types of transistors, etc.). Also, the integrated circuit 100 can include an amplifier 221, where the amplifier 221 has a variable gain. The integrated circuit 100 can also include a gm-stage 222 and a gm-stage 223 connected to the amplifier 221. Further, the integrated circuit 100 can include a resistor 251 and a capacitor 252 connected in parallel to the switch 213, along with a transistor 253 and a transistor 254 connected to the resistor 251 and the capacitor 252. In some examples, the resistor 251 can be the same as or similar to the resistor 171, and the capacitor 252 can be the same as or similar to the capacitor 160 as shown in FIG. 1. The components shown as being part of the integrated circuit 100 in FIG. 2 (e.g., within the dashed box of FIG. 2) provide an example implementation of the amplifier 140 as shown in FIG. 1.

The integrated circuit 100 as shown in FIG. 2 can include various additional components used to implement the amplifier 140 as shown in FIG. 1 (e.g., a dual-stage amplifier). For example, the integrated circuit 100 can include a bias current 231, a bias current 232, and a bias current 233. The integrated circuit 100 can include a transistor 241, a transistor 242, a transistor 243, a transistor 244, a transistor 245, a transistor 246, a transistor 247, and a transistor 248 that are variously connected to the bias current 231, the bias current 232, and the bias current 233. The transistor 241, a transistor 242, a transistor 243, a transistor 244, a transistor 245, a transistor 246, a transistor 247, the transistor 248, the transistor 253, the transistor 254, and the transistor 265 can be implemented using various suitable types of transistors (e.g., metal-oxide-semiconductor field-effect transistors (MOSFETs), bipolar junction transistors (BJTs), etc.). The switch 211 and the switch 212 can be used to separate the two stages of the amplifier 140. For example, the switch 211 can lead back to the feedback elements of the amplifier 140 (e.g., the resistor 171 and the capacitor 160) for signal amplification. Then, the switch 212 can lead to the switch 214, and thereby to the current source circuit.

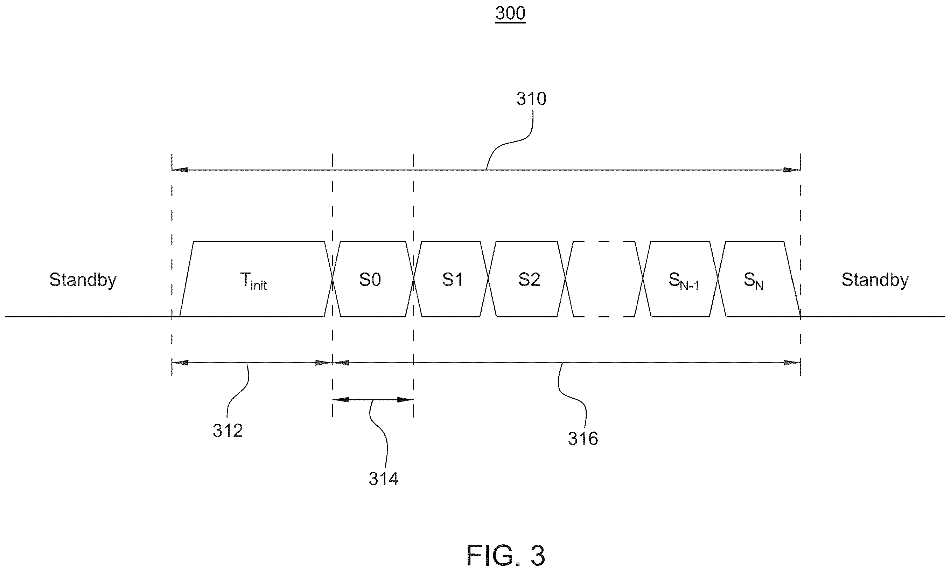

Referring to FIG. 3, a diagram illustrating an example timing sequence 300 that can be implemented in the integrated circuit 100 is shown, in accordance with some aspects of the disclosure. For example, the controller 190 can execute machine-readable instructions stored in memory to implement the timing sequence 300. The timing sequence 300 includes a time period 310 that encompasses the total scan time for a single scan that can be performed by the integrated circuit 100. The timing sequence 300 also includes a time period 312 that encompasses an initialization time period ("Tᵢₙᵢₜ"). During the time period 312, the scan begins and the controller 190 measures the ambient current that is indicative of the ambient light at the input associated with the photodiode 710 (e.g., at the pin 112) using the output of the ADC circuit 180. During the time period 312, the controller 190 can measure ambient currents associated with any photodiodes connected to the integrated circuit 100, including the photodiode 710.

Then, during the time period 314, the controller 190 causes the current source circuit (e.g., including the capacitor 261, the resistor 262, the transistor 265, and the resistor 266 as shown in FIG. 2) to provide a compensatory current to the amplifier 140 to at least partially cancel the ambient current associated with the photodiode 710 (at slot zero, or "S0"). Then, after the time period 314, the controller 190 can cause any compensatory currents to be provided to amplifiers associated with any additional number of photodiodes (S_{N}) connected to the integrated circuit 100 besides the photodiode 710. The provision of all compensatory currents is reflected in the timing diagram 300 by a time period 316 that includes the time period 314. During the time period 316, the controller 190 can also open the switch 214 and the switch 212 to facilitate the provision of the compensatory current(s). As such, the integrated circuit 100 can generally operate in accordance with two main phases. During the first phase, the integrated circuit 100 can perform measurement of the ambient currents associated with any connected photodiodes. Then, during the second phase, the integrated circuit 100 can operate normally to measure current signals from any connected photodiodes while at least partially canceling the measured ambient currents. The time periods shown in the example timing diagram 300 can be any suitable length time periods. Accordingly, the integrated circuit 100 can provide a dual-phase, time-interleaved TIA circuit.

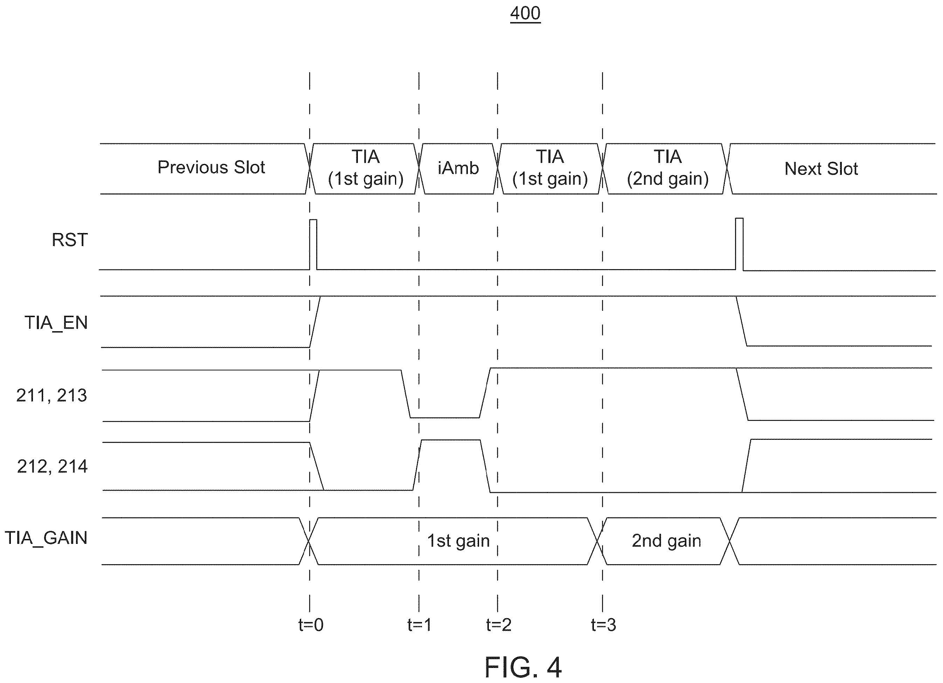

Referring to FIG. 4, a diagram illustrating another example timing sequence 400 that can be implemented in the integrated circuit 100 is shown, in accordance with some aspects of the disclosure. For example, the controller 190 can execute machine-readable instructions stored in memory to implement the timing sequence 400. The timing sequence 400 is more detailed than the timing sequence 300 in that is shows the timing sequence withing every time slot (e.g., S0, S1, etc.). In particular, the timing sequence illustrates five different variables (signals) associated with the integrated circuit 100 on the y-axis plotted with respect to time on the x-axis. Also, four main times are shown at the bottom of the timing sequence 400, along with four main time periods on the top of the timing sequence 400. Generally, in the timing sequence 400 as shown in FIG. 4, a "reset" is performed for a single slot (e.g., for a single photodiode connected to the integrated circuit 100, such as the photodiode 710). The variables shown include (i) a "reset" signal (RST); (ii) a TIA enable signal (TIA_EN); (iii) an on/off status of the switches 211 and 213 as shown in FIG. 2; (iv) an on/off status of the switches 212 and 214 as shown in FIG. 2; and (v) a TIA gain setting.

At time t=0, the controller 190 resets the measured ambient current as well as the compensatory current functionality associated with the photodiode 710. Here, the controller 190 resets the capacitor 263 gets reset, and also sets the amplifier 140 to a first gain. The controller 190 can set the amplifier 140 to the first gain by adjusting the resistor 171. The controller 190 can set the first gain to be at or near the lowest possible gain setting for the amplifier 140 to bring the input node close to its correct quiescent value, for example. Also, at time t=0, the controller 190 can turn on the switch 211 and the switch 213 while turning off the switch 212 and the switch 214. Then, at time t=1, the controller 190 can configure the integrated circuit 100 to measure the ambient current associated with the integrated circuit 100. To do so, the controller 190 can turn off the switch 211 and the switch 213 while turning on the switch 212 and the switch 214. Next, at time t=2, the controller 190 can configured the integrated circuit 100 to measure the input current associated with the photodiode 710 while keeping the amplifier 140 set to the first gain. To do so, the controller 190 can turn on the switch 211 and the switch 213 while turning off the switch 212 and the switch 214. Finally, at t=3, the controller 190 can set the amplifier 140 to a second gain by adjusting the resistor 171. The second gain can generally be a "desired" gain that is higher than the first gain and helps free up the useful dynamic range of the amplifier 140. As a result, the amplifier 140 can achieve a better signal to noise ratio, and the integrated circuit can also achieve improvements in terms of power efficiency. The time periods as shown in the example timing diagram 400 can be any suitable length time periods.

The controller 190 can generally be configured to, during a first time period, measure an approximate ambient current associated with the photodiode 170 using the ADC circuit 180; during a second time period, measure the ambient current more precisely using the amplifier 140; and, during a third time period, cause the current source circuit to provide a compensatory current to the amplifier 140 to cancel the ambient current. Also, the second and third time periods can be repeated for every slot to measure the ambient current precisely and cancel it in the third time period.

The following are further embodiments of the invention:
1. An integrated circuit, comprising:
   a first pin connectable to a photodiode to receive an input current from the photodiode;
   an amplifier connected to the first pin;
   a second pin connected to the amplifier to provide an output voltage indicative of the input current from the photodiode;
   a current source circuit connected between the first pin and the second pin;
   a switch connected between the current source circuit and the second pin; and
   a controller configured to:
      during a first time period, measure a first current associated with the photodiode; and
      during a second time period, open the switch and cause the current source circuit to provide a second current to the amplifier to at least partially cancel the first current.
2. The integrated circuit of embodiment 1, comprising an analog-to-digital converter (ADC) circuit connected between the second pin and the current source circuit.
3. The integrated circuit of embodiment 2, wherein the ADC circuit has a resolution between 2 bits and 4 bits.
4. The integrated circuit of embodiment 3, wherein an output of the ADC circuit is indicative of a current range associated with the first current.
5. The integrated circuit of embodiment 1, comprising a variable resistor connected between an output terminal of the amplifier and an inverting input of the amplifier.
6. The integrated circuit of embodiment 5, wherein the controller is configured to adjust the variable resistor to set a first gain for the amplifier during the first time.
7. The integrated circuit of embodiment 6, wherein the controller is configured to adjust the variable resistor to set a second gain for the amplifier during the second time, the second gain being higher than the first gain and the second gain being based on the first current.
8. The integrated circuit of embodiment 1, wherein the current source circuit comprises a floating current source circuit.
9. The integrated circuit of embodiment 1, comprising a capacitor connected between the switch and the current source circuit to hold a bias for the current source circuit.
10. The integrated circuit of embodiment 9, wherein the current source circuit comprises a transistor, wherein a gate terminal of the transistor is connected to the switch.
11. The integrated circuit of embodiment 10, wherein the current source circuit comprises a variable capacitor and a variable resistor, the variable capacitor and the variable resistor being connected in parallel between the capacitor and the transistor.
12. The integrated circuit of embodiment 11, wherein the current source circuit comprises a second variable resistor connected between the amplifier and ground.
13. An integrated circuit, comprising:
   a first pin connectable to a photodiode to receive an input current from the photodiode;
   an amplifier connected to the first pin;
   a second pin connected to the amplifier to provide an output voltage indicative of the input current from the photodiode;
   a current source circuit connected between the first pin and the second pin;
   an analog-to-digital converter (ADC) circuit connected between the second pin and the current source circuit; and
   a controller configured to:
      during a first time period, measure a first current associated with the photodiode using the ADC circuit; and
      during a second time period, cause the current source circuit to provide a second current to the amplifier to at least partially cancel the first current.
14. The integrated circuit of embodiment 13, comprising a switch connected between the current source circuit and the second pin.
15. The integrated circuit of embodiment 14, wherein the controller is configured to close the switch during the first time.
16. The integrated circuit of embodiment 15, wherein the controller is configured to open the switch during the second time.
17. The integrated circuit of embodiment 13, comprising a variable resistor connected between an output terminal of the amplifier and an inverting input of the amplifier, wherein the controller is configured to adjust the variable resistor to control a gain of the amplifier based on the first current.
18. An integrated circuit, comprising:
   a first pin connectable to a photodiode to receive an input current from the photodiode;
   an amplifier connected to the first pin;
   a second pin connected to the amplifier to provide an output voltage indicative of the input current from the photodiode;
   a current source circuit connected between the first pin and the second pin;
   a switch connected between the current source circuit and the second pin;
   an analog-to-digital converter (ADC) circuit connected between the second pin and the switch; and
   a controller configured to:
      during a first time period, measure a first current associated with the photodiode using the ADC circuit; and
      during a second time period, open the switch and cause the current source circuit to provide a second current to the amplifier to at least partially cancel the first current.
19. The integrated circuit of embodiment 18, comprising a variable resistor connected between an output terminal of the amplifier and an inverting input of the amplifier, wherein the controller is configured to adjust the variable resistor to control a gain of the amplifier based on the first current.
20. The integrated circuit of embodiment 18, wherein the ADC circuit has a resolution between 2 bits and 4 bits.

## Claims

1. An integrated circuit, comprising:
a first pin connectable to a photodiode to receive an input current from the photodiode;
an amplifier connected to the first pin;
a second pin connected to the amplifier to provide an output voltage indicative of the input current from the photodiode;
a current source circuit connected between the first pin and the second pin;
a switch connected between the current source circuit and the second pin; and
a controller configured to:
during a first time period, measure a first current associated with the photodiode; and
during a second time period, open the switch and cause the current source circuit to provide a second current to the amplifier to at least partially cancel the first current.

2. The integrated circuit of claim 1, comprising an analog-to-digital converter (ADC) circuit connected between the second pin and the current source circuit.

3. The integrated circuit of claim 2, wherein the ADC circuit has a resolution between 2 bits and 4 bits,
in particular,
wherein an output of the ADC circuit is indicative of a current range associated with the first current.

4. The integrated circuit of one of the previous claims, comprising a variable resistor connected between an output terminal of the amplifier and an inverting input of the amplifier.

5. The integrated circuit of claim 4, wherein the controller is configured to adjust the variable resistor to set a first gain for the amplifier during the first time,
in particular,
wherein the controller is configured to adjust the variable resistor to set a second gain for the amplifier during the second time, the second gain being higher than the first gain and the second gain being based on the first current.

6. The integrated circuit of one of the previous claims, wherein the current source circuit comprises a floating current source circuit.

7. The integrated circuit of one of the previous claims, comprising a capacitor connected between the switch and the current source circuit to hold a bias for the current source circuit.

8. The integrated circuit of claim 7, wherein the current source circuit comprises a transistor, wherein a gate terminal of the transistor is connected to the switch.

9. The integrated circuit of claim 8, wherein the current source circuit comprises a variable capacitor and a variable resistor, the variable capacitor and the variable resistor being connected in parallel between the capacitor and the transistor,
in particular,
wherein the current source circuit comprises a second variable resistor connected between the amplifier and ground.

10. An integrated circuit, comprising:
a first pin connectable to a photodiode to receive an input current from the photodiode;
an amplifier connected to the first pin;
a second pin connected to the amplifier to provide an output voltage indicative of the input current from the photodiode;
a current source circuit connected between the first pin and the second pin;
an analog-to-digital converter (ADC) circuit connected between the second pin and the current source circuit; and
a controller configured to:
during a first time period, measure a first current associated with the photodiode using the ADC circuit; and
during a second time period, cause the current source circuit to provide a second current to the amplifier to at least partially cancel the first current.

11. The integrated circuit of claim 10, comprising a switch connected between the current source circuit and the second pin.

12. The integrated circuit of claim 11, wherein the controller is configured to close the switch during the first time,
in particular,
wherein the controller is configured to open the switch during the second time.

13. The integrated circuit of one of claims 10 to 12, comprising a variable resistor connected between an output terminal of the amplifier and an inverting input of the amplifier, wherein the controller is configured to adjust the variable resistor to control a gain of the amplifier based on the first current.

14. An integrated circuit, comprising:
a first pin connectable to a photodiode to receive an input current from the photodiode;
an amplifier connected to the first pin;
a second pin connected to the amplifier to provide an output voltage indicative of the input current from the photodiode;
a current source circuit connected between the first pin and the second pin;
a switch connected between the current source circuit and the second pin;
an analog-to-digital converter (ADC) circuit connected between the second pin and the switch; and
a controller configured to:
during a first time period, measure a first current associated with the photodiode using the ADC circuit; and
during a second time period, open the switch and cause the current source circuit to provide a second current to the amplifier to at least partially cancel the first current.

15. The integrated circuit of claim 14, comprising a variable resistor connected between an output terminal of the amplifier and an inverting input of the amplifier, wherein the controller is configured to adjust the variable resistor to control a gain of the amplifier based on the first current
and/or
wherein the ADC circuit has a resolution between 2 bits and 4 bits.
